# FASCICULE DE BREVET EUROPEEN

(11) **EP 3 476 665 B1**
(45) Date de publication et mention de la délivrance du brevet: **13.05.2020**
(21) Numéro de dépôt: 18199707.3
(22) Date de dépôt: 10.10.2018
(51) Int. Cl.: H05K 7/14

(54) **BARRE D'ISOLATION ÉLÉCTRIQUE, NOTAMMENT POUR UN MODULE ÉLÉCTRONIQUE DE PUISSANCE D'UN ONDULEUR**
ELEKTRISCHE ISOLIERLEISTE, INSBESONDERE FÜR EIN ELEKTRONISCHES LEISTUNGSMODUL EINES WECHSELRICHTERS
ELECTRICAL INSULATION BAR, IN PARTICULAR FOR A POWER ELECTRONICS MODULE OF AN INVERTER

(30) Priorité: 26.10.2017 FR 1760116
(43) Date de publication de la demande: 01.05.2019
(73) Titulaire: Valeo Siemens eAutomotive France SAS, 95800 Cergy (FR)
(72) Inventeur: LAMARCHE, Anthony, 78450 VILLEPREUX (FR); GILET, Olivier, 95270 VIARMES (FR)
(74) Mandataire: Argyma

(56) Documents cités:
- EP-A1- 1 796 221
- EP-A1- 2 725 661
- FR-A1- 3 039 354
- JP-A- 2002 246 104
- US-A1- 2004 235 364

## Description

### DOMAINE TECHNIQUE ET OBJET DE L'INVENTION

La présente invention se rapporte au domaine des barres de connexion mises en œuvre pour relier deux systèmes d'électronique de puissance, tels que, dans un onduleur, un module électronique de puissance et un bloc capacitif par exemple. Plus précisément, la présente invention concerne une barre d'isolation électrique pour isoler des bornes de connexion d'un système électrique, tel que celles émergeant d'un module électronique de puissance d'un onduleur, afin d'assurer une fonction supplémentaire d'isolation électrique vis-à-vis d'un châssis dans lequel ledit onduleur est disposé.

L'invention vise notamment à permettre d'assurer une isolation électrique dans les cas où l'espace disponible entre les bornes de connexion d'un système électrique et le châssis dans lequel ledit système est disposé est insuffisant pour assurer une isolation électrique par l'intermédiaire de l'air situé entre lesdites bornes de connexion et ledit châssis.

L'invention vise aussi, dans un mode de réalisation, à assurer une fonction anti-rotation des bornes de connexion d'un système électrique.

### ETAT DE LA TECHNIQUE

Comme cela est connu, en électronique de puissance, des systèmes électriques, tels que des onduleurs, comprennent des composants intégrés dans des châssis généralement métalliques. Une isolation électrique est nécessaire entre les connecteurs des composants d'électronique de puissance et les parois intérieures de tels châssis.

Dans les systèmes connus, l'air est généralement le média isolant électrique utilisé. Cependant, aujourd'hui, des contraintes liées à des exigences de compacité entraînent que des connecteurs électriques de composants d'électronique de puissance se retrouvent trop près de la paroi du châssis qui les intègre pour permettre une isolation électrique suffisante.

Cette problématique est particulièrement forte dans le domaine automobile, et plus particulièrement dans le domaine des véhicules électriques et hybrides, car les composants d'électroniques de puissance y sont prépondérants et que les exigences de compacité y sont exacerbées.

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Plus précisément, afin de commander le moteur électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Un onduleur comprend un module électronique de puissance connecté à un bloc capacitif au moyen d'une barre de connexion reliant des connecteurs, également désignés « bornes de connexion », « conducteurs électriques », ou encore « leadframes », selon le terme en langue anglaise bien connu de l'homme du métier.

Il est précisé que par « module électronique de puissance », on entend un ensemble comprenant des composants par lesquels passe de l'énergie alimentant la machine électrique, notamment destinés à transformer le courant continu en courants alternatifs ou vice-versa. Ces composants peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants sont des puces semi-conductrices nues pour lesquels le corps réalise une encapsulation. Autrement dit, un module électronique de puissance est un ensemble comprenant une pluralité de puces semi-conductrices formant un circuit électrique encapsulées dans un même boîtier.

Aujourd'hui, à des fins de réduction du volume occupé par les systèmes électriques embarqués, dans un véhicule électrique ou hybride, l'onduleur de puissance est amené à être directement accolé au moteur électrique, en particulier au niveau du train arrière alors que, dans l'état de l'art, l'onduleur est relié au moteur électrique par un faisceau de câbles.

En pratique, l'onduleur se retrouve en butée contre le bloc moteur électrique, une simple fenêtre étant prévue dans les châssis respectifs de l'onduleur et du moteur électrique afin de permettre de relier les phases.

Dans ce contexte particulier, a fortiori, la problématique exposée précédemment, relative à l'isolation électrique entre les bornes de connexion du module électronique de puissance de l'onduleur et le châssis, se pose. Il n'existe en effet potentiellement pas d'espace suffisant entre la barre de connexion reliant les bornes de connexion du module électronique de puissance et le bloc capacitif disposé en dessous, dans l'onduleur, et la paroi intérieure du châssis intégrant ledit onduleur.

Ce problème est d'autant plus important, dans le contexte particulier présenté ci-dessus, qu'un jeu est nécessaire entre le châssis de l'onduleur et, d'un côté, le moteur électrique et, de l'autre, le réservoir de carburant dans le cas d'un véhicule hybride.

La paroi du châssis de l'onduleur se trouve alors potentiellement trop proche du module électronique de puissance, en particulier de la barre de connexion à laquelle sont reliées les bornes de connexion du module électronique de puissance et du bloc capacitif, dans l'onduleur.

L'isolation électrique par le média air est potentiellement insuffisante.

Pour pallier ce problème, l'état de la technique connaît deux types de solution. Une première solution connue consiste à déposer une pièce en plastique, formant une bassine isolante, sur la partie métallique du châssis, pour en isoler la paroi intérieure. Cette pièce est injectée, thermoformée, et collée dans le châssis. Les inconvénients attachés à cette solution résident notamment dans le coût induit, cette technique nécessitant notamment un outillage dédié pour l'usinage de la pièce en plastique, ainsi qu'une opération supplémentaire de collage.

Le document EP 2725661 A1 décrit un exemple de barre de connexion électrique comprenant des conducteurs électriques avec, à une extrémité, des trous d'attache pour visser des connecteurs d'un équipement électrique aux conducteurs électriques et, à l'autre extrémité, des bornes de connexion de câbles. La barre de connexion électrice, selon ce document EP 2725661 A1, est logé dans un boîtier d'isolation électrique.

Une autre solution connue consiste à glisser une feuille isolante entre la barre de connexion du module électronique de puissance au bloc capacitif et la paroi intérieure du châssis. Cependant, une telle opération est longue et délicate, et donc coûteuse.

Il existe donc le besoin pour un dispositif apte à assurer une isolation électrique adéquate entre les bornes de connexion d'un module électronique de puissance d'un onduleur et la paroi du châssis hébergeant ledit onduleur, de façon simple à implémenter et peu coûteuse.

Pour répondre à ce besoin, la présente invention propose la création d'une barre de connexion supplémentaire, en matériau isolant, avec des inserts métalliques de compression assurant la fonction d'entretoises pour le vissage de ladite barre de connexion supplémentaire, ladite barre de connexion supplémentaire assurant une fonction d'isolation électrique.

### PRESENTATION GENERALE DE L'INVENTION

A cet effet, plus précisément, l'invention a tout d'abord pour objet une barre d'isolation électrique pour un système électrique, ladite barre d'isolation électrique comprenant un corps en matériau isolant électriquement, présentant une section en forme de 'L' comportant deux branches s'étendant orthogonalement l'une à l'autre suivant une direction respective orthogonale au plan de ladite section en forme de 'L', lesdites deux branches formant un angle droit destiné à recevoir une borne de connexion dudit système électrique, une première branche de la barre d'isolation électrique étant destinée à être positionnée directement ou indirectement en appui contre une face de la borne de connexion du système électrique et une deuxième branche, orthogonale à la première branche, étant configurée pour s'étendre en vis-à-vis de la borne de connexion du système électrique de manière à réaliser une isolation électrique de la borne de connexion du système électrique.

Grâce à la barre d'isolation électrique selon l'invention, les bornes de connexion d'un composant d'électronique de puissance intégré dans un châssis sont isolées de la paroi intérieure située en vis-à-vis desdites bornes de connexion.

Selon un mode de réalisation, ladite barre d'isolation électrique selon l'invention comporte au moins un insert métallique noyé dans la masse du corps et accessible depuis une ouverture traversante du corps, de sorte que ladite barre d'isolation électrique forme une interface de serrage, destinée à être fixée sur la borne de connexion du système électrique au moyen d'une tige engagée dans ladite ouverture traversante.

Selon un mode de réalisation, le corps comprend au moins une nervure et/ou au moins un muret aménagé(s) dans la masse du corps et situé(s) entre deux portions de la première branche, destinées à recevoir deux bornes de connexion différentes du système électrique, ladite au moins une nervure et/ou ledit au moins un muret s'étendant parallèlement à une direction selon laquelle lesdites portions sont destinées à recevoir lesdites bornes de connexion différentes, de manière à assurer une isolation électrique entre lesdites deux bornes de connexion différentes du système électrique.

La présente invention vise également un ensemble d'un système électrique et d'une barre d'isolation électrique telle que brièvement décrite ci-dessus, ladite barre d'isolation étant configurée pour isoler au moins une borne de connexion du système électrique.

Selon une forme de réalisation, un tel ensemble comprend une languette conductrice entre le corps en matériau isolant électriquement et ladite au moins une borne de connexion, pour assurer un contact électrique avec ladite au moins une borne de connexion du système électrique, à travers ledit corps en matériau isolant électriquement, afin de prélever un signal électrique directement sur ladite au moins une borne de connexion du système électrique.

Avantageusement, ladite languette conductrice est partiellement noyée dans la masse du corps en matériau isolant électriquement.

Alternativement, ladite languette conductrice peut être insérée à force dans la masse du corps en matériau isolant électriquement.

Selon un mode de réalisation, ledit signal est destiné à être acheminé à une carte de contrôle du système électrique, notamment de manière à déterminer une pente de variation de l'intensité du courant circulant dans ladite borne de connexion du système électrique.

Selon un mode de réalisation, la barre d'isolation électrique est configurée pour permettre la fixation d'une barre conductrice électrique sur la borne de connexion du système électrique.

Un tel système électrique est par exemple un module électronique de puissance. Ladite barre conductrice électrique est par exemple une borne de connexion d'un bloc capacitif.

Avantageusement, ladite barre d'isolation électrique étant disposée sur une première face de la borne de connexion du système électrique, une deuxième face de la borne de connexion opposée à la première face recevant une barre conductrice électrique de manière à connecter électriquement le système électrique, le corps de ladite barre d'isolation électrique assurant une isolation électrique de la borne de connexion du système électrique vis-à-vis d'une paroi du châssis.

Selon un mode de réalisation, la borne de connexion du système électrique et la paroi du châssis sont à proximité l'une de l'autre, et la deuxième branche de la barre d'isolation électrique est située entre la paroi du châssis et la borne de connexion du système électrique de manière à éviter un vis-à-vis direct entre ladite paroi du châssis et la dite borne de connexion du système électrique.

Selon une forme de réalisation, la borne de connexion du système électrique et la barre conductrice électrique comprennent chacun un trou traversant venant en correspondance avec le trou traversant de l'insert métallique, et la barre d'isolation électrique est configurée pour en outre fixer la barre conductrice électrique sur la borne de connexion du système électrique par l'intermédiaire d'une tige engagée dans le trou de la borne de connexion du système électrique et coopérant avec le trou de la barre conductrice électrique.

Avantageusement, ladite tige est une vis filetée et ladite barre de connexion électrique comprend un insert taraudé serti apte à coopérer avec ladite vis filetée pour assurer la fixation de la barre conductrice électrique sur la borne de connexion du système électrique.

### PRESENTATION DES FIGURES

L'invention sera mieux comprise à la lecture de la description qui va suivre, se référant aux dessins annexés donnés à titre d'exemples non limitatifs, dans lesquels des références identiques sont données à des objets semblables et sur lesquels :
- la figure 1 est une vue de dessus de la barre d'isolation électrique selon l'invention,
- la figure 2 est une vue en coupe de la barre d'isolation électrique selon l'invention,
- la figure 3 est une première vue en perspective de la barre d'isolation électrique selon l'invention,
- la figure 4 est une seconde vue en perspective de la barre d'isolation électrique selon l'invention,
- la figure 5 montre une vue de profil la barre d'isolation électrique selon l'invention, mise en œuvre dans un système électrique.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite plus particulièrement dans son application à un véhicule automobile électrique ou hybride sans que cela ne soit limitatif de la portée de la présente invention.

Dans l'exemple décrit ci-après, on vise en particulier une mise en œuvre de l'invention dans un véhicule comprenant notamment une machine électrique, un système électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

La mise en œuvre de l'invention dans un onduleur ne doit toutefois pas être interprétée comme limitant la portée de la présente invention. Dans les exemples décrits ci-après, ledit onduleur comporte un module électronique de puissance relié à un bloc capacité et la barre d'isolation électrique selon l'invention est prévue en particulier pour être disposée à l'interface entre les connecteurs électriques du module électronique de puissance et ceux du bloc capacitif.

On notera cependant que le système électrique considéré pourrait être autre chose qu'un onduleur, par exemple un chargeur ou un convertisseur DCDC embarqués.

Dans l'application particulière envisagée pour la présente invention, c'est-à-dire dans un onduleur embarqué dans un véhicule automobile électrique ou hybride, il est rappelé que l'onduleur est notamment configuré pour alimenter une machine électrique du véhicule. Une telle machine électrique est alors une machine électrique tournante, de préférence destinée à entrainer les roues du véhicule à partir de l'énergie fournie par la batterie d'alimentation haute-tension. Plus précisément, la machine électrique est ainsi une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par une batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

De manière connue, un onduleur comprend un boîtier, également désigné châssis, dans lequel sont montés un module électronique de puissance, une unité électronique de contrôle et un bloc capacitif connecté au module électronique de puissance.

Le châssis comprend des parois latérales et un couvercle monté sur les parois latérales. Le châssis comprend également une paroi inférieure s'étendant entre les parois latérales et qui forme le fond du châssis, l'ensemble formé par le bloc capacitif et le module électronique de puissance pouvant être supporté par ledit fond.

Toujours de manière connue, le module électronique de puissance comprend, de manière non limitative, cinq connecteurs, également désignés bornes de connexion, ou encore « leadframes » selon le terme en langue anglaise connu de l'homme de l'art, reliés à six connecteurs électriques correspondant du bloc capacitif.

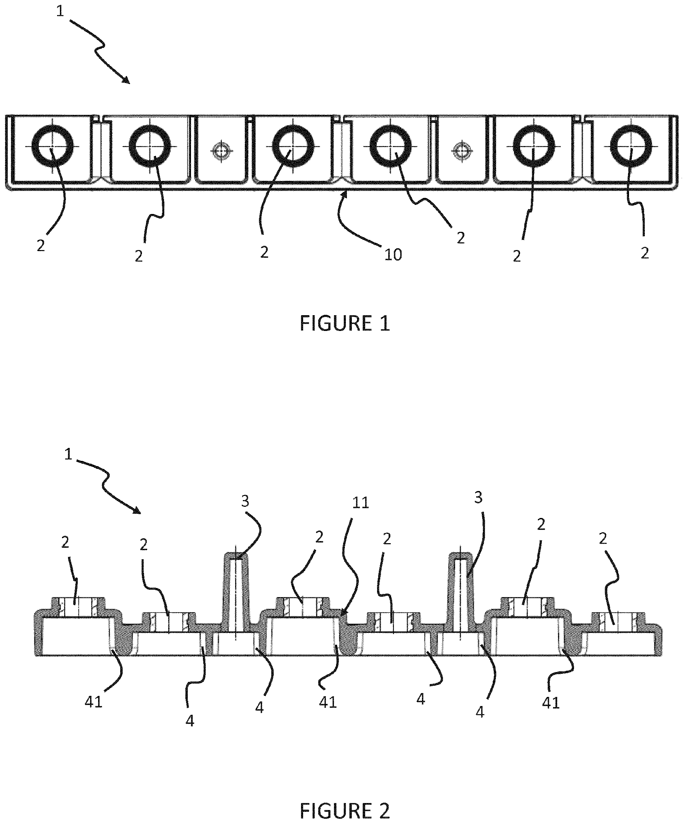

A cette fin, en référence aux figures 1 à 4, la barre d'isolation électrique 1 selon l'invention permet la connexion des bornes de connexion, d'un module électronique de puissance d'onduleur par exemple, aux connecteurs électriques correspondants, d'un bloc capacitif par exemple.

En référence à la figure 1, la présente invention consiste en une barre d'isolation électrique 1. Dans l'exemple préféré illustré aux figures 1 à 4, la barre d'isolation électrique 1 est une pièce monobloc en matériau isolant, par exemple en plastique. La barre 1 est alors réalisée d'un seul tenant, qui peut avantageusement être produite par injection plastique.

La barre d'isolation électrique 1 présente une forme générale allongée, avec une embase 11 sensiblement plane, comprenant des ouvertures 2, et une portion plane formant un muret « massif » 10 s'étendant orthogonalement à l'embase 11 et destiné à s'étendre parallèlement à la paroi d'un châssis intégrant le système électrique considéré. La barre d'isolation électrique 1 présente ainsi une section sensiblement en forme de 'L', comportant une première branche formant l'embase 11 et une deuxième branche formant le muret « massif » 10.

Les ouvertures 2 comprennent des futs métalliques permettant le passage de vis filetées pour la fixation de la barre d'isolation électrique 1.

La barre d'isolation électrique 1 comporte par ailleurs des logements pour recevoir des connecteurs électriques, tels que les bornes de connexion d'un module électronique de puissance d'un onduleur.

Lorsque lesdites bornes de connexion sont engagées dans lesdits logements, ladite barre d'isolation électrique 1 est adaptée pour être fixée par vis sur le système électrique considéré, l'embase 11, au niveau desdits logements, venant en appui contre une face desdites bornes de connexion.

La barre d'isolation électrique 1 est une pièce en matériau isolant comprenant des inserts métalliques, autrement dit des futs, formant des entretoises métalliques pour le vissage de la barre d'isolation électrique 1 sur une ou plusieurs bornes de connexion d'un système électrique, tel qu'un module électronique de puissance d'un onduleur.

Ladite barre d'isolation électrique 1 est par exemple en plastique et peut être réalisée par injection de matière plastique, procédé connu de l'homme de l'art.

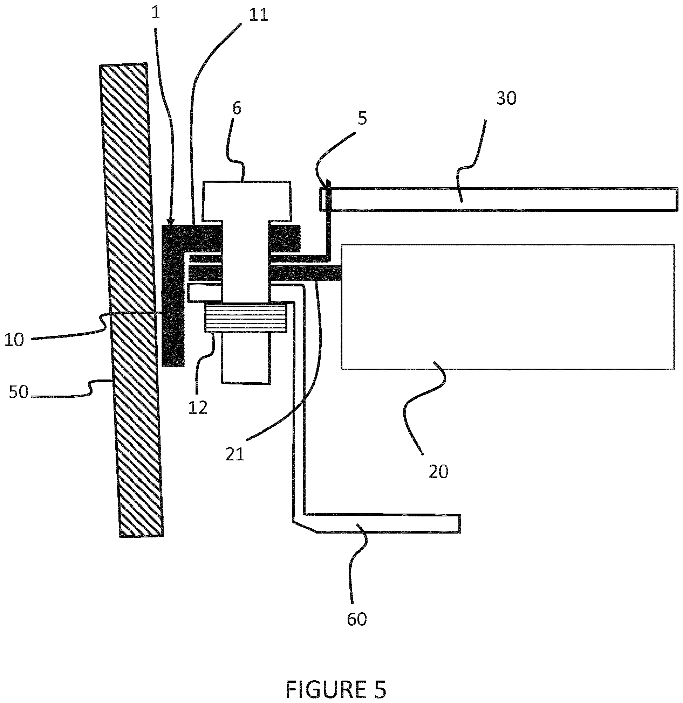

Les inserts métalliques sont prévus dans des ouvertures traversantes 2 percées dans la barre 1. Comme le montre la figure 5, ces futs métalliques permettent le passage de vis filetées 6 tout en prévenant tout risque d'écrasement de la matière isolante, tel que du plastique, constitutif de la barre d'isolation électrique 1, lors du serrage de ladite ou desdites vis 6 dans le(s)dit(s) fut(s) métallique(s).

Toujours en référence à la figure 5, la barre d'isolation électrique 1 est prévue pour être prise « en sandwich » entre des bornes de connexion d'un système électrique, telles que les cinq bornes de sortie d'un module électronique de puissance d'un onduleur, et des vis de serrage 6 passants par les inserts métalliques disposés dans les ouvertures 2 aménagées dans le masse de la barre 1 en matériau isolant.

Comme cela est représenté sur la figure 2 notamment, la barre d'isolation électrique 1 comprend par ailleurs, de préférence, des plots 3 configurés pour permettre la manipulation aisée de ladite barre 1 lors de son assemblage sur un système électrique.

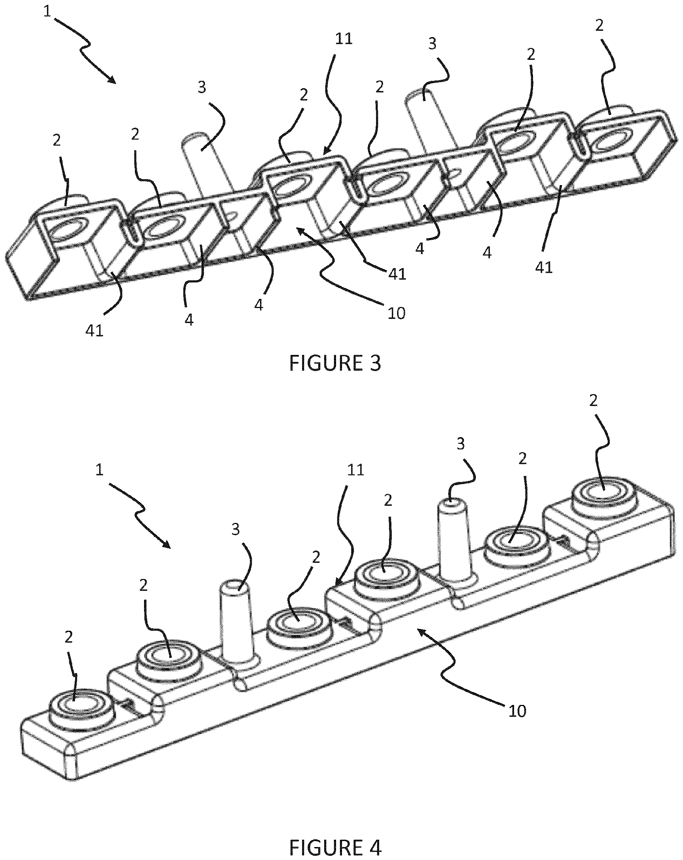

Selon un mode de réalisation préféré, comme représenté en particulier sur la figure 3, des murets orthogonaux 4, 41 sont aménagés pour augmenter l'isolation électrique entre les bornes de connexion, en particulier vis-à-vis de courants de fuite surfaciques.

De cette façon, lorsque la barre d'isolation électrique 1 selon l'invention comporte plusieurs logements, par exemple six logements, sur différentes portions correspondantes de la première branche 11 de la barre 1, pour recevoir six bornes de connexion, les murets orthogonaux 4, 41 assurent une isolation électrique entre lesdites bornes de connexion. Les murets orthogonaux 4, 41 permettent d'empêcher tout court-circuit entre les bornes de connexion et bloquent les éventuels courants de fuite surfacique.

Autrement dit, lorsque deux portions différentes de la première branche 11 de la barre d'isolation électrique 1 reçoivent deux bornes de connexion différentes d'un système électrique, au moins un muret 4, 41, ou au moins une nervure, s'étend parallèlement à la direction selon laquelle lesdites portions reçoivent lesdites bornes de connexion différentes, de manière à assurer une isolation électrique entre lesdites deux bornes de connexion différentes du système électrique.

En particulier, pour améliorer la fonction d'isolation électrique entre les bornes de connexion, vis-à-vis des courants de fuites surfaciques susceptibles de se diffuser dans la masse de la barre 1, la longueur du chemin à parcourir dans la masse de la barre 1, par lesdits courants de fuite surfacique, est de préférence maintenue supérieure ou égale à un seuil, par exemple au moins 8 mm. A cette fin, certains murets 41 présentent une forme de U.

Ces murets orthogonaux 4, 41, éventuellement en forme de U, ont pour fonction principale d'assurer une isolation électrique entre les bornes de connexion du système électrique au niveau desquelles la barre d'isolation électrique 1 est mise en œuvre, en particulier vis-à-vis des courants de fuite.

Selon un mode de réalisation alternatif, plutôt que des murets 4, 41, il peut être prévu des nervures aménagées dans la masse de la barre d'isolation électrique 1.

La deuxième branche de la barre 1 forme un muret « massif » 10, parallèle à la paroi du châssis, destinée à se trouver en vis-à-vis, et configuré pour assurer quant à lui la fonction principale d'isolation électrique des bornes de connexion du système électrique, tel qu'un module électronique de puissance, par rapport à la paroi du châssis dans lequel il se trouve.

Le muret « massif » 10 présente une épaisseur adaptée pour garantir l'isolation électrique entre les bornes de connexion du système électrique et la paroi du châssis dans lequel ledit système électrique se trouve.

La figure 5 montre un exemple de mise en œuvre de la barre d'isolation électrique 1 dans un système électrique, par exemple un onduleur. Dans l'exemple de la figure 5, un système électrique est disposé dans un châssis 50. Ledit système électrique est par exemple un onduleur comprenant un module électronique de puissance 20 avec une carte de contrôle 30. Le module électronique de puissance 20 est connecté via une borne de connexion 21 à un bloc capacitif dont est représentée uniquement sa propre borne de connexion 60, qui se présente sous la forme d'une barre conductrice électrique apte à connecter électriquement le module électronique de puissance 20 au bloc capacitif (non représenté en tant que tel).

Par l'intermédiaire d'au moins une vis 6, la barre d'isolation électrique 1 et les bornes de connexion 21, 60, respectivement du module électronique de puissance 20 et d'un bloc capacitif, sont reliées. A cette fin, par exemple, un insert taraudé 12 est serti sur la borne de connexion 60 dudit bloc capacitif. La vis 6 coopère avec cet insert taraudé 12 pour permettre la fixation de l'ensemble.

La barre d'isolation électrique 1 assure l'isolation électrique des bornes de connexion 21, 60, en particulier de la borne de connexion 21 du module électronique de puissance 20, vis-à-vis de la paroi 50 du système électrique.

Sans la présence de ladite barre d'isolation électrique 1, selon le contexte, une proximité trop grande entre la borne de connexion 21 du module électronique de puissance 20 et la paroi 50 ne permettrait pas de garantir l'isolation électrique entre ladite borne 21 et ladite paroi 50.

Par ailleurs, toujours selon le mode de réalisation de la figure 5, une languette conductrice 5, désignée languette di/dt, est intégrée à la barre d'isolation électrique 1. La languette di/dt 5 est ainsi disposée entre le matériau isolant du corps de la barre d'isolation électrique 1 et la borne de connexion 21. Selon un premier mode de réalisation, ladite languette di/dt 5 est enserrée, autrement dit « prise en sandwich », entre le corps en matériau isolant de la barre d'isolation électrique 1 et ladite borne de connexion 21. Alternativement, ladite languette di/dt 5 est partiellement noyée dans la masse, c'est-à-dire dans le corps en matériau isolant, de ladite barre d'isolation électrique 1. Selon un autre mode de réalisation, ladite languette di/dt 5 est partiellement insérée à force dans le corps en matériau isolant de la barre d'isolation électrique 1.

La languette di/dt 5 assure un contact avec la borne de connexion 21 du module électronique de puissance 20, à travers la barre d'isolation électrique 1, afin de prélever un signal électrique directement sur ladite borne de connexion 21.

Ledit signal est par exemple représentatif de la pente de variation de l'intensité du courant dans ladite borne de connexion 21, ledit signal étant destiné à être acheminé à une carte électronique de contrôle 30 du module électronique de puissance 20.

Grâce à la barre d'isolation électrique 1, la languette di/dt 5 s'insère dans un logement défini entre deux murets d'isolation 4, 41, ce qui l'empêche de tourner. Une telle rotation risquerait de l'endommager, voire de l'arracher à la carte électronique de contrôle 30. Autrement dit, la languette di/dt 5 est adaptée pour assurer une fonction anti-rotation de la barre d'isolation électrique 1 dans le plan de l'embase 11.

La languette di/dt 5 est par exemple constituée d'une languette en forme de chat d'aiguille insérée à force dans la barre d'isolation électrique 1, par exemple selon une technique connue désignée « press-fit ». La languette di/dt 5 est prévue pour être en contact avec une borne de connexion du module électronique de puissance 20.

En l'absence de la barre d'isolation électrique 1, intermédiaire en matériau isolant entre les vis de fixation 6 et la borne de connexion 21, la surface de contact entre une telle languette di/dt 5 et la sous-tête d'une telle vis de fixation 6 serait importante, ce qui poserait un problème car le couple de vissage endommagerait la liaison « press-fit » décrite ci-dessus.

Ladite languette di/dt 5 est en outre maintenue au contact de ladite borne de connexion 21 par pression de l'embase 11 de la barre d'isolation électrique 1 qui vient en appui sur toute la surface de la languette 5.

L'invention ne se limite pas aux seuls exemples décrits ci-dessus. Les figures représentent un exemple particulier de réalisation qui combine plusieurs modes de réalisation. Cependant, les caractéristiques liées aux modes de réalisation peuvent être indépendantes entre elles d'un mode à l'autre, ou combinées entre elles.

## Revendications

1. Barre d'isolation électrique (1) pour un système électrique (20), ladite barre d'isolation électrique (1) comprenant un corps en matériau isolant électriquement, présentant une section en forme de 'L' comportant deux branches (10, 11) s'étendant orthogonalement l'une à l'autre suivant une direction respective orthogonale au plan de ladite section en forme de 'L', lesdites deux branches (10, 11) formant un angle droit destiné à recevoir une borne de connexion (21) dudit système électrique (20), une première branche (11) de la barre d'isolation électrique (1) étant destinée à être positionnée directement ou indirectement en appui contre une face de la borne de connexion (21) du système électrique (20) et une deuxième branche (10), orthogonale à la première branche (11), étant configurée pour s'étendre en vis-à-vis de la borne de connexion (21) du système électrique (20) de manière à réaliser une isolation électrique de la borne de connexion (21) du système électrique (20).

2. Barre d'isolation électrique (1) selon la revendication 1, comportant au moins un insert métallique noyé dans la masse du corps et accessible depuis une ouverture (2) traversante du corps, de sorte que ladite barre d'isolation électrique (1) forme une interface de serrage, destinée à être fixée sur la borne de connexion (21) du système électrique (20) au moyen d'une tige engagée dans ladite ouverture (2) traversante.

3. Barre d'isolation électrique (1) selon l'une des revendications précédentes, ledit corps comprenant au moins une nervure et/ou au moins un muret (4, 41) aménagé(s) dans la masse du corps et situé(s) entre deux portions de la première branche (11), destinées à recevoir deux bornes de connexion différentes du système électrique (20), ladite au moins une nervure et/ou ledit au moins un muret (4, 41) s'étendant parallèlement à une direction selon laquelle lesdites portions sont destinées à recevoir lesdites bornes de connexion différentes, de manière à assurer une isolation électrique entre lesdites deux bornes de connexion différentes du système électrique (20).

4. Ensemble d'un système électrique (20) et d'une barre d'isolation électrique (1) selon l'une des revendications précédentes, ladite barre d'isolation électrique (1) étant configurée pour isoler au moins une borne de connexion (21) du système électrique (20).

5. Ensemble selon la revendication précédente, comprenant une languette conductrice (5) entre le corps en matériau isolant électriquement et ladite au moins une borne de connexion (21), pour assurer un contact électrique avec ladite au moins une borne de connexion (21) du système électrique (20), à travers ledit corps en matériau isolant électriquement, afin de prélever un signal électrique directement sur ladite au moins une borne de connexion (21) du système électrique (20).

6. Ensemble selon la revendication précédente, dans lequel ladite languette conductrice (5) est partiellement noyée dans la masse du corps en matériau isolant électriquement.

7. Ensemble selon la revendication 5 ou 6, dans lequel ledit signal est destiné à être acheminé à une carte de contrôle (30) du système électrique (20), notamment de manière à déterminer une pente de variation de l'intensité du courant circulant dans ladite borne de connexion (21) du système électrique (20).

8. Ensemble selon l'une des revendications 4 à 7, dans lequel la barre d'isolation électrique (1) est configurée pour permettre la fixation d'une barre conductrice électrique (60) sur la borne de connexion (21) du système électrique (20).

9. Equipement électrique comprenant un châssis (50), contenant un ensemble selon l'une des revendications 4 à 8, ladite barre d'isolation électrique (1) étant disposée sur une première face de la borne de connexion (21) du système électrique (20), une deuxième face de la borne de connexion (21) opposée à la première face recevant une barre conductrice électrique (60) de manière à connecter électriquement le système électrique (20), le corps de ladite barre d'isolation électrique (1) assurant une isolation électrique de la borne de connexion (21) du système électrique (20) vis-à-vis d'une paroi du châssis (50).

10. Equipement électrique selon la revendication précédente, dans lequel la borne de connexion (21) du système électrique (20) et la paroi du châssis (50) sont à proximité l'une de l'autre, et dans lequel la deuxième branche de la barre d'isolation électrique (1) est située entre la paroi du châssis (50) et la borne de connexion (21) du système électrique (20) de manière à éviter un vis-à-vis direct entre ladite paroi du châssis (50) et la dite borne de connexion (21) du système électrique (20).

11. Equipement électrique selon la revendication 9 ou 10, comprenant une barre d'isolation électrique (1) selon la revendication 2, dans lequel la borne de connexion (21) du système électrique (20) et la barre conductrice électrique (60) comprennent chacun un trou traversant venant en correspondance avec le trou traversant de l'insert métallique, et dans lequel la barre d'isolation électrique (1) est configurée pour en outre fixer la barre conductrice électrique (60) sur la borne de connexion (21) du système électrique (20) par l'intermédiaire d'une tige engagée dans le trou de la borne de connexion (21) du système électrique (20) et coopérant avec le trou de la barre conductrice électrique (60).

12. Equipement électrique selon la revendication précédente, ladite tige étant une vis filetée (6) et ladite barre de connexion électrique (60) comprenant un insert taraudé (12) serti apte à coopérer avec ladite vis filetée (6) pour assurer la fixation de la barre conductrice électrique (60) sur la borne de connexion (21) du système électrique (20).

## Patentansprüche

1. Elektrische Isolierleiste (1) für ein elektrisches System (20), wobei die elektrische Isolierleiste (1) einen Körper aus elektrisch isolierendem Material umfasst, der einen Querschnitt in ,L'-Form aufweist, aufweisend zwei Schenkel (10, 11), die sich orthogonal zueinander gemäß einer Richtung erstrecken, die zur Ebene des Querschnitts in ,L'-Form jeweils orthogonal ist, wobei die zwei Schenkel (10, 11) einen rechten Winkel bilden, der zur Aufnahme einer Anschlussklemme (21) des elektrischen Systems (20) bestimmt ist, wobei ein erster Schenkel (11) der elektrischen Isolierleiste (1) bestimmt ist, sich direkt oder indirekt auf einer Fläche der Anschlussklemme (21) des elektrischen Systems (20) positioniert abzustützen und ein zweiter Schenkel (10), der orthogonal zum ersten Schenkel (11) ist, konfiguriert ist, um sich gegenüber der Anschlussklemme (21) des elektrischen Systems (20) derart zu erstrecken, dass eine elektrische Isolierung der Anschlussklemme (21) des elektrischen Systems (20) durchgeführt wird.

2. Elektrische Isolierleiste (1) nach Anspruch 1, aufweisend mindestens einen metallischen Einsatz, der in die Masse des Körpers eingelassen und über eine Durchgangsöffnung (2) des Körpers erreichbar ist, so dass die elektrische Isolierleiste (1) eine Spannschnittstelle bildet, die zur Befestigung auf der Anschlussklemme (21) des elektrischen Systems (20) mittels eines Stabs bestimmt ist, der in die Durchgangsöffnung (2) eingesetzt ist.

3. Elektrische Isolierleiste (1) nach einem der vorangehenden Ansprüche, wobei der Körper mindestens eine Rippe und/oder mindestens ein Wandteil (4, 41) umfasst, die/der in der Masse des Körpers eingerichtet ist/sind und sich zwischen zwei Abschnitten des ersten Schenkels (11) befindet/befinden, die zur Aufnahme von zwei verschiedenen Anschlussklemmen des elektrischen Systems (20) bestimmt sind, wobei sich die mindestens eine Rippe und/oder der mindestens eine Wandteil (4, 41) parallel zu einer Richtung erstreckt/erstrecken, gemäß der die Abschnitte bestimmt sind, die verschiedenen Anschlussklemmen aufzunehmen, so dass eine elektrische Isolierung zwischen den zwei verschiedenen Anschlussklemmen des elektrischen Systems (20) gesichert ist.

4. Einheit aus einem elektrischen System (20) und einer elektrischen Isolierleiste (1) nach einem der vorangehenden Ansprüche, wobei die elektrische Isolierleiste (1) konfiguriert ist, um mindestens eine Anschlussklemme (21) des elektrischen Systems (20) zu isolieren.

5. Einheit nach vorangehendem Anspruch, umfassend eine leitende Zunge (5) zwischen dem Körper aus elektrisch isolierendem Material und der mindestens einen Anschlussklemme (21), um einen elektrischen Kontakt mit der mindestens einen Anschlussklemme (21) des elektrischen Systems (20) durch den Körper aus elektrisch isolierendem Material zu sichern, um ein elektrisches Signal direkt auf der mindestens einen Anschlussklemme (21) des elektrischen Systems (20) abzunehmen.

6. Einheit nach vorangehendem Anspruch, wobei die leitende Zunge (5) teilweise in die Masse des Körpers aus elektrisch isolierendem Material eingelassen ist.

7. Einheit nach Anspruch 5 oder 6, wobei das Signal zur Beförderung zu einer Steuerkarte (30) des elektrischen Systems (20) bestimmt ist, insbesondere derart, um ein Stärkevariationsgefälle des Stroms zu bestimmen, der in der Anschlussklemme (21) des elektrischen Systems (20) zirkuliert.

8. Einheit nach einem der Ansprüche 4 bis 7, wobei die elektrische Isolierleiste (1) konfiguriert ist, um die Befestigung einer elektrischen Stromschiene (60) auf der Anschlussklemme (21) des elektrischen Systems (20) zu erlauben.

9. Elektrische Ausrüstung, umfassend einen Rahmen (50), der eine Einheit nach einem der Ansprüche 4 bis 8 enthält, wobei die elektrische Isolierleiste (1) auf einer ersten Fläche der Anschlussklemme (21) des elektrischen Systems (20) angeordnet ist, wobei eine zweite Fläche der Anschlussklemme (21) gegenüber der ersten Fläche eine elektrische Stromschiene (60) derart aufnimmt, um das elektrische System (20) elektrisch anzuschließen, wobei der Körper der elektrischen Isolierleiste (1) eine elektrische Isolierung der Anschlussklemme (21) des elektrischen Systems (20) gegenüber einer Wand des Rahmens (50) sichert.

10. Elektrische Ausrüstung nach vorangehendem Anspruch, wobei die Anschlussklemme (21) des elektrischen Systems (20) und der Wand des Rahmens (50) in der Nähe zueinander sind, und wobei sich der zweite Schenkel der elektrischen Isolierleiste (1) zwischen der Wand des Rahmens (50) und der Anschlussklemme (21) des elektrischen Systems (20) befindet, so dass ein direktes Gegenüber zwischen der Wand des Rahmens (50) und der Anschlussklemme (21) des elektrischen Systems (20) vermieden wird.

11. Elektrische Ausrüstung nach Anspruch 9 oder 10, umfassend eine elektrische Isolierleiste (1) nach Anspruch 2, wobei die Anschlussklemme (21) des elektrischen Systems (20) und die elektrische Stromschiene (60) jeweils ein Durchgangsloch umfassen, das in Übereinstimmung mit dem Durchgangsloch des metallischen Einsatzes kommt, und wobei die elektrische Isolierleiste (1) konfiguriert ist, um ferner die elektrische Stromschiene (60) auf der Anschlussklemme (21) des elektrischen Systems (20) über einen Stab zu befestigen, der in das Loch der Anschlussklemme (21) des elektrischen Systems (20) eingesetzt ist und mit dem Loch der elektrischen Stromschiene (60) zusammenwirkt.

12. Elektrische Ausrüstung nach vorangehendem Anspruch, wobei der Stab eine Gewindeschraube (6) ist und die elektrische Stromschiene (60) einen verpressten Gewindeeinsatz (12) umfasst, der imstande ist, mit der Gewindeschraube (6) zusammenzuwirken, um die Befestigung der elektrischen Stromschiene (60) auf der Anschlussklemme (21) des elektrischen Systems (20) zu sichern.

## Claims

1. Electrical insulation bar (1) for an electrical system (20), said electrical insulation bar (1) comprising a body made of an electrically insulating material, having an L-shaped cross-section comprising two branches (10, 11) extending orthogonally to each other in respective directions orthogonal to the plane of said L-shaped cross-section, said two branches (10, 11) forming a right angle for receiving a connection terminal (21) of said electrical system (20), a first branch (11) of the electrical insulation bar (1) being configured to be positioned directly or indirectly against a face of the connection terminal (21) of the electrical system (20) and a second branch (10), orthogonal to the first branch (11), being configured to extend facing the connection terminal (21) of the electrical system (20) in such a manner as to electrically insulate the connection terminal (21) of the electrical system (20).

2. Electrical insulation bar (1) according to claim 1, being provided with at least one metal insert embedded in the thickness of the body and accessible from a through opening (2) extending through the body, so that said electrical insulation bar (1) forms a clamping interface, configured to be fastened to the connection terminal (21) of the electrical system (20) by means of a rod engaged in said through opening (2).

3. Electrical insulation bar (1) according to either of the preceding claims, said body being provided with at least one rib and/or with at least one wall (4, 41) provided in the thickness of the body and situated between two portions of the first branch (11), which portions are configured to receive respective ones of two different connection terminals of the electrical system (20), said at least one rib and/or said at least one wall (4, 41) extending parallel to a direction in which said portions are configured to receive said different connection terminals, in such a manner as to guarantee electrical insulation between said two different connection terminals of the electrical system (20).

4. Assembly made up of an electrical system (20) and of an electrical insulation bar (1) according to any preceding claim, said electrical insulation bar (1) being configured to insulate at least one connection terminal (21) of the electrical system (20).

5. Assembly according to the preceding claim, further including a conductive tongue (5) between the body made of the electrically insulating material and said at least one connection terminal (21) so as to guarantee electrical contact with said at least one connection terminal (21) of the electrical system (20), through said body made of the electrically insulating material, in order to take an electrical signal directly from said at least one connection terminal (21) of the electrical system (20).

6. Assembly according to the preceding claim, wherein said conductive tongue (5) is partially embedded in the thickness of the body made of the electrically insulating material.

7. Assembly according to claim 5 or claim 6, wherein said signal is to be conveyed to a control card (30) of the electrical system (20), in particular in such a manner as to determine a gradient of variation of the current flowing in said connection terminal (21) of the electrical system (20).

8. Assembly according to any one of claims 4 to 7, wherein the electrical insulation bar (1) is configured to enable an electrically conductive bar (60) to be fastened to the connection terminal (21) of the electrical system (20).

9. Electrical equipment having a housins (50), containing an assembly according to any one of claims 4 to 8, said electrical insulation bar (1) being disposed on a first face of the connection terminal (21) of the electrical system (20), a second face of the connection terminal (21) opposite from the first face receiving an electrically conductive bar (60) in such a manner as to electrically connect the electrical system (20), the body of said electrical insulation bar (1) electrically insulating the connection terminal (21) of the electrical system (20) from a wall of the housing (50).

10. Electrical equipment according to the preceding claim, wherein the connection terminal (21) of the electrical system (20) and the wall of the housing (50) are close to each other, and wherein the second branch of the electrical insulation bar (1) is situated between the wall of the housing (50) and the connection terminal (21) of the electrical system (20) in such a manner as to avoid said wall of the housing (50) directly facing said connection terminal (21) of the electrical system (20).

11. Electrical equipment according to claim 9 or 10, including an electrical insulation bar (1) according to claim 2, wherein the connection terminal (21) of the electrical system (20) and the electrically conductive bar (60) are each provided with a respective through hole coming into register with the through hole in the metal insert, and wherein the electrical insulation bar (1) is configured so as also to fasten the electrically conductive bar (60) to the connection terminal (21) of the electrical system (20) by means of a rod engaged in the hole in the connection terminal (21) of the electrical system (20) and co-operating with the hole in the electrically conductive bar (60).

12. Electrical equipment according to the preceding claim, said rod being a threaded screw (6) and said electrical connection bar (60) being provided with a crimped tapped insert (12) suitable for co-operating with said threaded screw (6) so as to fasten the electrically conductive bar (60) onto the connection terminal (21) of the electrical system (20).
